# EUROPEAN PATENT APPLICATION

(11) **EP 0 933 822 A2**
(43) Date of publication of application: **04.08.1999**
(21) Application number: 99300362.3
(22) Date of filing: 19.01.1999
(51) Int. Cl.: H01L 31/068, H01L 31/18, H01L 31/0352, H01L 31/0236

(54) **Substrate for forming high-strenght thin semiconductor element and method for manufacturing high-strength thin semiconductor element**

(30) Priority: 20.01.1998 JP 900298
(71) Applicant: Sharp Kabushiki Kaisha, Osaka-shi, Osaka 545-8522 (JP)
(72) Inventor: Anzawa, Osamu, Kitakatsuragi-gun, Nura 639-2122 (JP)
(74) Representative: Brown, Kenneth Richard

(57) **Abstract**

A substrate for forming a high-strength thin semiconductor element includes a thick portion and a thin portion in the front surface or in both front and rear surfaces of the substrate, the thick portion maintaining a thickness of the substrate as initially used or having a thickness that gives a sufficient strength to the substrate, the thin portion being formed by selectively removing a portion of the substrate other than the thick portion and having a thickness smaller than the thick portion and larger than or equal to 20 µm.

## Description

### CROSS-REFERENCES TO RELATED APPLICATIONS

This application is related to Japanese patent application No. HEI 10-009002 filed on January 20, 1998 whose priority is claimed under 35 USC §119, the disclosure of which is incorporated herein by reference in their entirety.

### BACKGROUND OF THE INVENTION

### 1. Field of the Invention

The present invention relates to a substrate for forming a high-strength thin semiconductor element and a method for manufacturing a high-strength thin semiconductor element. More particularly, the present invention relates to a substrate for forming a thin semiconductor element capable of maintaining a high strength and realizing reduction of its weight and thickness, a high-strength thin semiconductor element formed by using this substrate, and a method for manufacturing a high-strength thin semiconductor element using this substrate.

### 2. Description of the Related Art

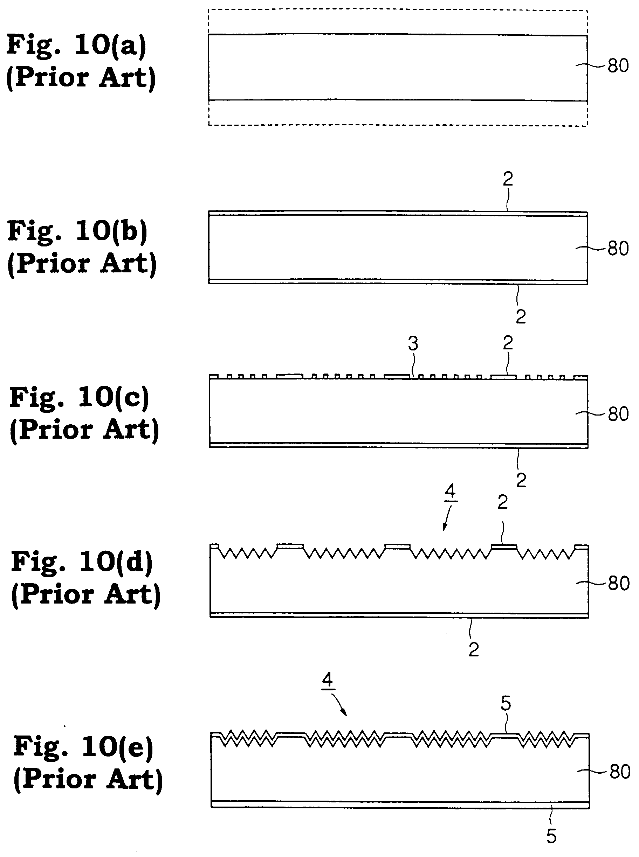

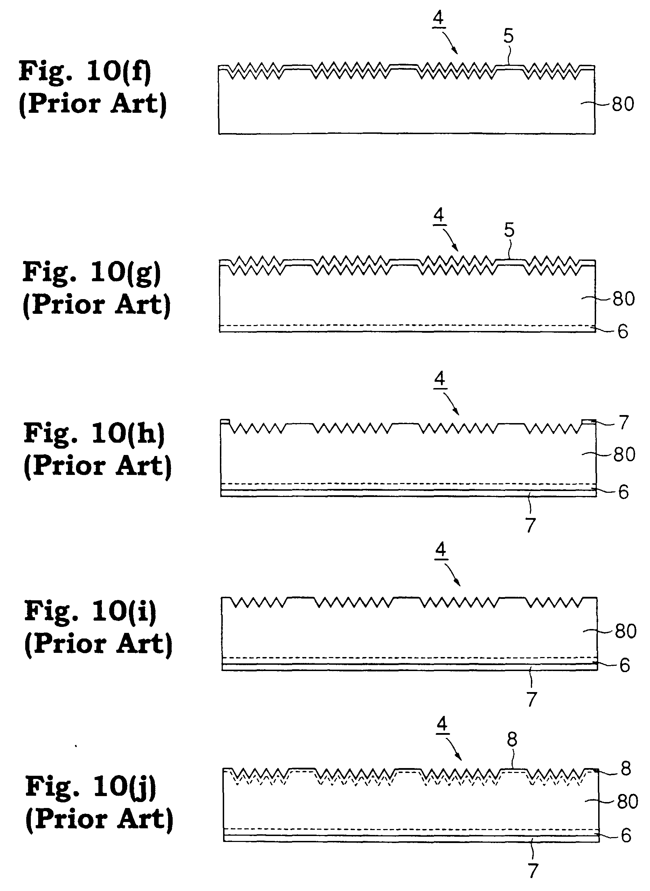

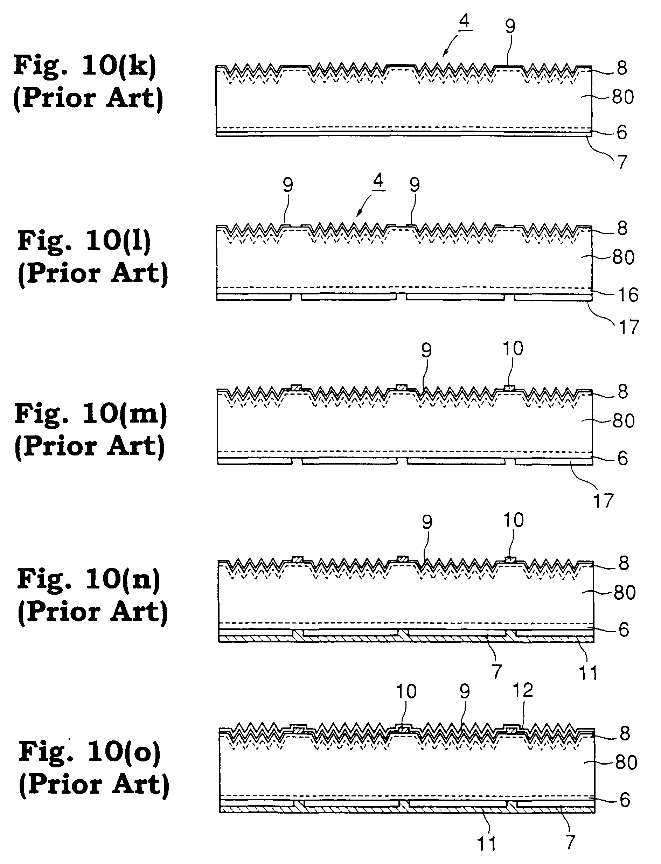

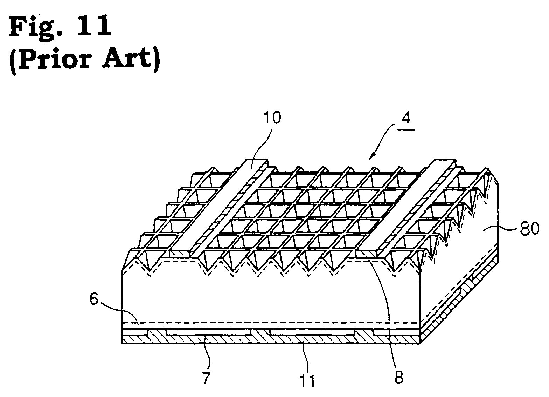

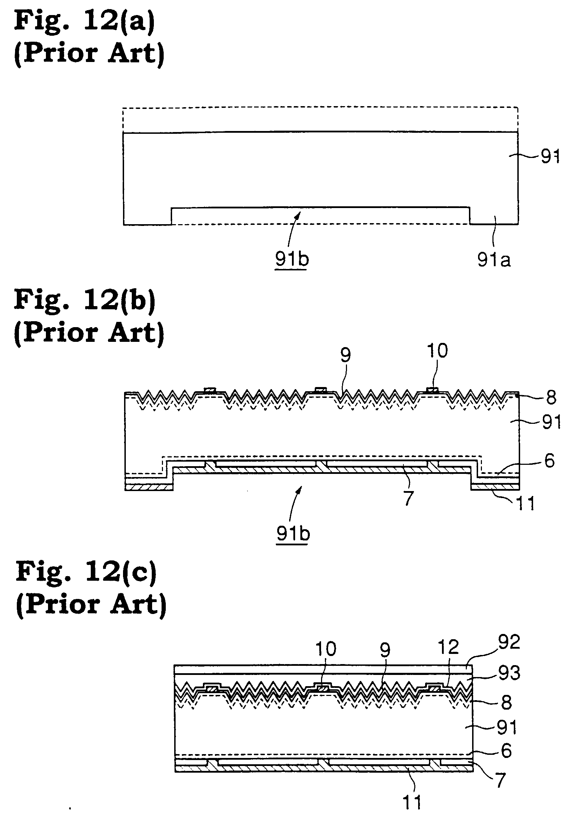

Solar cells for the universe proposed hitherto are generally manufactured as follows.
(1) A silicon substrate 80 having a thickness of about 200 to about 300 µm as initially used is chemically etched to a final solar cell thickness of about 50 to about 200 µm uniformly by a thinning etching step (Fig. 10(a)).
(2) An oxide film 2 is formed on both surfaces of the substrate 80 by a first oxidation step (Fig. 10(b)).
(3) A window 3 having a reflection-free surface configuration pattern is opened through the oxide film 2 by the photoetching technique (oxide film window opening step: Fig. 10(c)).
(4) Only a portion of the substrate 80 where the oxide film 2 has been removed by the above oxide film window opening step is etched to form a reflection-free surface configuration 4 on the front surface of the substrate 80 for reducing reflection of light (texture etching step : Fig. 10(d)). Here, by leaving the oxide film 2 to have a predetermined pattern in the previous step, this reflection-free surface configuration 4 will have an inverse pyramid structure (See Fig. 11).
(5) An oxide film 5 is formed again on both surfaces of the substrate 80 by a second oxidation step (Fig. 10(e)).
(6) The oxide film 5 formed on the rear surface of the substrate 80 is removed by a chemical treatment in order to diffuse a p-type dopant into the rear surface (Fig. 10(f)).
(7) A p-type diffusion layer 6 is formed in the rear surface of the substrate 80 by diffusing boron (Fig. 10(g)).
(8) An oxide film 7 is formed over the entire rear surface of the substrate 80 by the CVD method for protection of the rear surface (Fig. 10(h)).
(9) The oxide film 7 formed by the CVD method and turning around onto the front surface (a light-receiving surface) of the substrate 80 is removed by a chemical treatment (Fig. 10(i)).
(10) An n-type diffusion layer 8 is formed only in the light-receiving surface by diffusing phosphorus into the front surface of the substrate 80 (Fig. 10 (j)).
(11) A passivation film (oxide film) 9 is formed on the n-type diffusion layer 8 in the front surface of the substrate 80 by thermally oxidizing the substrate 80 (Fig. 10(k)).
(12) An electrode-contact portion of the oxide film 7 formed by the CVD method on the rear surface of the substrate 80 in the step (8) is removed by the photoetching technique for connection between an electrode formed in a later step and the diffusion layer 6 (Fig. 10(l)). Also, an electrode-contact portion of the passivation film 9 formed on the front surface of the substrate 80 in the step (11) is removed by the photoetching technique for connection between an electrode formed in a later step and the diffusion layer 8 (Fig. 10(l)).
(13) A light-receiving surface electrode 10 having a predetermined shape is formed on the front surface of the substrate 80 for connection with the n-type diffusion layer 8 (N-electrode deposition step : Fig. 10(m)).
(14) The substrate 80 is cut into a predetermined size for the purpose of simplifying the treatments to be performed in the later steps (dicing breaking step I).
(15) The rear surface electrode 11 having a predetermined shape is formed on the rear surface of the substrate 80 for connection with the p-type diffusion layer 6 (P-electrode deposition step: Fig. 10(n)).
(16) A reflection-preventive film 12 is formed on the front surface of the substrate 80 for reducing reflection of light (reflection-preventive film deposition step : Fig. 10(o)).
(17) A thermal treatment is carried out to increase the degree of contact of the light-receiving surface electrode 10 and rear surface electrode 11 formed in the N/P-electrode deposition steps, with the substrate 80 (sintering step).
(18) The substrate 80 is cut into a final solar cell dimension (dicing breaking step II).
   The solar cell element is completed by the above steps (1) to (18) (Fig. 11).
   Solar cells for the universe are generally used in a universe space, so that a high resistance to radioactive rays is required in their element properties themselves.
   One of the effective techniques for achieving high resistance to radioactive rays is to reduce the substrate thickness of the solar cell element. However, this technique involves a problem that the silicon substrate must be chemically etched to a final solar cell thickness in the initial step (1) of fabricating the element, so that the substrate thickness cannot be reduced below a thickness (about 50 µm or less) having a sufficient strength to enable the treatments to be performed later. Also, the smaller thickness the substrate is made to have in the initial step (1), the more skill and the more carefulness are needed in the later step, requiring a great amount of labor. Also, a processing apparatus for manufacturing the solar cell element for the universe requires a higher substrate transport stability as compared with a general apparatus used in manufacturing a semiconductor element, thereby restricting the selection of apparatus.
   Accordingly, Japanese Unexamined Patent Publication No. Hei 04(1992)-192474, for example, proposes a technique of maintaining a large thickness only in the periphery of the rear surface of the substrate and reducing the thickness of the other portion of the rear surface and front surface so as to ensure a sufficient strength to enable the treatments to be performed in the later steps while reducing the substrate thickness.
   (1) First, a p-type silicon substrate having a thickness of 200 to 300 µm with a crystal face direction of [100] is initially used as a substrate to form a coating film (not shown) in the periphery of the rear surface of the substrate which surface is opposite to the front surface of the substrate which surface will act as a light-receiving surface when the solar cell is completed. The coating film is made of an etching-resistant material such as SiO₂ or Si₃N₄ formed by the CVD method or an acid-resistant and alkali-resistant wax. Next, the silicon substrate 91 is chemically etched to a final solar cell thickness by a thinning etching step. At this time, the coated portion in the periphery of the rear surface of the substrate 91 remains unetched to form a reinforcing member 91a having a larger thickness (about 100 to about 250 µm) than the other portion, whereby a thin portion 91b (about 50 to about 200 µm) is formed in the central portion of the rear surface of the substrate 91 (Fig. 12(a)).
   Subsequently, steps similar to the above steps (2) to (13) and (15) are carried out to form an n-type diffusion layer 8, a passivation film 9 and a light-receiving surface electrode 10 on the front surface of the substrate 91 and to form a p-type diffusion layer 6, an oxide film 7 and the rear surface electrode 11 on the rear surface of the substrate 91 (Fig. 12(b)). At this time, since the reinforcing member 91a is provided in the periphery of the rear surface of the substrate 91, the substrate 91 can be prevented from being warped. Thereafter, steps similar to the above steps (16) and (17) are carried out.
(18) Subsequently, a cover glass 92 is stuck onto the front surface of the substrate 91 with an adhesive 93.
(19) The substrate 91 is cut to a final solar cell dimension together with the cover glass 92 (Fig. 12(c)). At this time, the reinforcing member 91a in the periphery of the rear surface of the substrate 91 is cut off. Here, the substrate 91 is prevented from being warped, since it is reinforced by the cover glass 92.

The solar cell element is completed by the above steps.

However, the above-mentioned method of forming the reinforcing member 91a in the periphery of the rear surface of the substrate 91 first and cutting off the reinforcing member 91a at the end of the steps involves several problems in manufacturing the solar cell element because the rear surface of the substrate 91 has an unevenness.

Generally, the rear surface electrode of a solar cell is formed over an entire surface of the solar cell, whereas a light-receiving surface electrode is formed to a full dimension of the solar cell in a fine, comb-like shape so as to increase the amount of light incident into the solar cell. Therefore, the cutting position of the solar cell is set with an extremely high precision relative to the position of the light-receiving surface electrode, so that an alignment mark is disposed on the front surface of the substrate which surface will act as a light-receiving surface of the solar cell. Accordingly, in cutting off the reinforcing member 91a at the above step (19), a dicing tape is stuck onto the rear surface of the substrate, the substrate is fixed on a dicing stage to align the substrate using the alignment mark on the front surface of the substrate as a reference, and a dicing blade is allowed to cut into the front surface side of the substrate 91 for dicing.

At this time, since the thin portion 91b of the substrate 91 is completely floating above the dicing tape for about 50 to 200 µm, a crack of the substrate 91 may be generated if a dicing pressure is exerted on this floating portion from the front surface side of the substrate 91. Also, since the portion that constitutes the solar cell element is not fixed on the dicing stage, the portion may scatter away due to the dicing operation.

Also, in the method of cutting off the reinforcing member 91a after the cover glass 92 is stuck as in the above step (19), it is necessary to form the cover glass 92 to a large thickness for giving a sufficient strength to the solar cell element as well as preventing the substrate 91 from being warped. However, in accordance with an increase in the thickness of the cover glass 92, its absorption of incident light increases, thereby deteriorating the characteristics of the solar cell element.

Further, according to the above method, since the front surface of the substrate 91 is flat, the following problems occur in the step which requires application of pressure over an entire surface of the substrate 91 from the front surface side.

For example, in the above step (19), the dicing tape is stuck onto the rear surface of the substrate by mounting the substrate on a tape sticking stage with the front surface of the substrate facing downwards and by rolling the dicing tape with a roller from above (from the rear surface side of the substrate) to press the dicing tape onto the rear surface of the substrate. At this time, if fine foreign substances (for example, dusts of the substrate or litters) are present on the stage, the pressure is concentrated on a contacting portion between the front surface of the substrate and foreign substances. Therefore, if the contacting portion is on the thin portion 91b of the substrate 91, the strength of the substrate itself is low and a great stress is applied to the thin portion 91b by the pressure applied from the reinforcing member 91a of the substrate, thereby generating cracks in the substrate.

### SUMMARY OF THE INVENTION

The present invention provides a substrate for forming a high-strength thin semiconductor element, comprising a thick portion and a thin portion in the front surface or in both front and rear surfaces of the substrate, the thick portion maintaining a thickness of the substrate as initially used or having a thickness that gives a sufficient strength to the substrate, the thin portion being formed by selectively removing a portion of the substrate other than the thick portion and having a thickness smaller than the thick portion and larger than or equal to 20 µm.

Also, the present invention provides a substrate for forming a high-strength thin semiconductor element, comprising a thick portion and a thin portion in the rear surface of the substrate, the thick portion maintaining a thickness of the substrate as initially used, the thin portion being formed by selectively removing a portion of the substrate other than the thick portion and having a thickness smaller than the thick portion and larger than or equal to 20 µm.

Further, the present invention provides a high-strength thin semiconductor element comprising an active layer formed in the above-mentioned substrate itself, a light-receiving surface electrode disposed on the front surface side of the substrate, and the rear surface electrode disposed on the rear surface side of the substrate.

Also, the present invention provides a method of manufacturing a high-strength thin semiconductor element comprising the step of selectively patterning and removing a portion of the front surface or both front and rear surfaces of a substrate by using a mask so as to leave a thick portion maintaining a thickness of the substrate as initially used or having a thickness that gives a sufficient strength to the substrate as well as to form a thin portion having a thickness smaller than the thick portion and larger than or equal to 20 µm.

Further, the present invention provides a method of manufacturing a high-strength thin semiconductor element comprising the step of selectively removing a portion of the rear surface of a substrate by using a mask so as to leave a thick portion maintaining a thickness of the substrate as initially used as well as to form a thin portion having a thickness smaller than the thick portion and larger than or equal to 20 µm.

### BRIEF DESCRIPTION OF THE DRAWINGS

The present invention will be better understood from the following detailed description of preferred embodiments of the invention, taken in conjunction with the accompanying drawings, in which:
Figs. 1(a) to 1(o) are schematic cross-sectional views showing steps for explaining the method for manufacturing the solar cell element for the universe which is a high-strength thin semiconductor element of the present invention (Example 1);
Fig. 2 is a schematic perspective view showing a substrate for explaining another method for manufacturing a solar cell element for the universe which is a high-strength thin semiconductor element of the present invention (Example 4, 14, 17);
Fig. 3 is a schematic perspective view showing a substrate for explaining still another method for manufacturing a solar cell element for the universe which is a high-strength thin semiconductor element of the present invention (Example 5, 15, 18);
Fig. 4 is a schematic perspective view showing a substrate for explaining still another method for manufacturing a solar cell element for the universe which is a high-strength thin semiconductor element of the present invention (Example 6, 16, 19);
Fig. 5 is a schematic perspective view showing an essential portion of a solar cell element for the universe for explaining still another method for manufacturing the solar cell element for the universe which is a high-strength thin semiconductor element of the present invention (Example 7);
Figs. 6(a) to 6(m) are schematic cross-sectional views showing steps for explaining the method for manufacturing the solar cell element for the universe which is a high-strength thin semiconductor element of the present invention (Example 8);
Figs. 7(a) to 7(b) are schematic cross-sectional views showing steps for explaining another method for manufacturing a solar cell element for the universe which is a high-strength thin semiconductor element of the present invention (Example 11);
Figs. 8(a) to 8(c) are schematic cross-sectional views showing steps for explaining still another method for manufacturing a solar cell element for the universe which is a high-strength thin semiconductor element of the present invention (Example 12);
Fig. 9 is a schematic cross-sectional view for explaining a step for explaining still another method for manufacturing a solar cell element for the universe which is a high-strength thin semiconductor element of the present invention (Example 13);
Figs. 10(a) to 10(o) are schematic cross-sectional views showing steps for explaining the method for manufacturing the conventional solar cell element for the universe;
Fig. 11 is a schematic perspective view of an essential portion of a solar cell element for the universe having an inverse pyramid configuration which is formed by a conventional method for manufacturing the solar cell element for the universe; and
Figs. 12(a) to 12(c) are schematic cross-sectional views showing steps for explaining another method for manufacturing a conventional solar cell element for the universe.

### DETAILED DESCRIPTION OF THE PREFERRED EMBODIMENTS

A substrate for forming a high-strength thin semiconductor element according to the present invention (hereafter referred to as "element-forming substrate") is a substrate obtained by reducing its thickness and weight while maintaining a suitable substrate strength.

The element-forming substrate represents a single substrate, including a wafer or the like, on which one or plural semiconductor elements are to be formed. The element-forming substrate may be a known substrate such as a semiconductor substrate made of silicon, germanium or the like, or a compound semiconductor substrate made of SiGe, GaP, GaAs or the like. Among these, a silicon substrate is preferable. Also, the substrate may contain either an n-type dopant such as phosphorus or a p-type dopant such as boron. If the substrate contains a dopant, the dopant is preferably contained at a concentration which is generally used in a semiconductor device, a solar cell or the like.

The element-forming substrate has a thick portion and a thin portion in the front surface, in the rear surface, or in both front and rear surfaces of the substrate.

If the thick portion and thin portion are formed in the front surface or in both the front and rear surfaces of the element-forming substrate, the thick portion contributes to maintain a thickness of the substrate as initially used or to maintain a thickness that gives a sufficient strength to the substrate. Here, the thickness of the substrate as initially used represents a substrate thickness such as used in forming an element, for example, a semiconductor device or a solar cell. Such a substrate thickness is not limited and may be, for example, about 200 to about 400 µm. The element-forming substrate may be a substrate obtained, for example, by cutting it out from an ingot, planarizing it, or polishing it before the initial introduction so that the substrate may have a suitable thickness. Here, the element-forming substrate preferably has a flat smooth surface. Generally, the substrate preferably has surface flatness and smoothness of about ± 2.0 µm in view of its close contact with an insulating film or an electrically conductive film that are to be formed on the substrate, and reflectivity to the received light. Also, to maintain a sufficient substrate strength is to have a substrate strength capable of withstanding the treatments performed in the later steps for forming the element, such as film formation, patterning, ion implantation, thermal treatment, transportation, cutting out and the like, even if the front surface and/or rear surface of the substrate as initially used is thinned by etching or the like. Here, it is possible to determine a suitable value for the substrate strength depending on the treatments for forming the element, on the shape, the size, the pattern or the like of the thick portion.

On the other hand, if the thick portion and thin portion are formed in the rear surface of the element-forming substrate, the thick portion preferably maintains the thickness of the substrate as initially used.

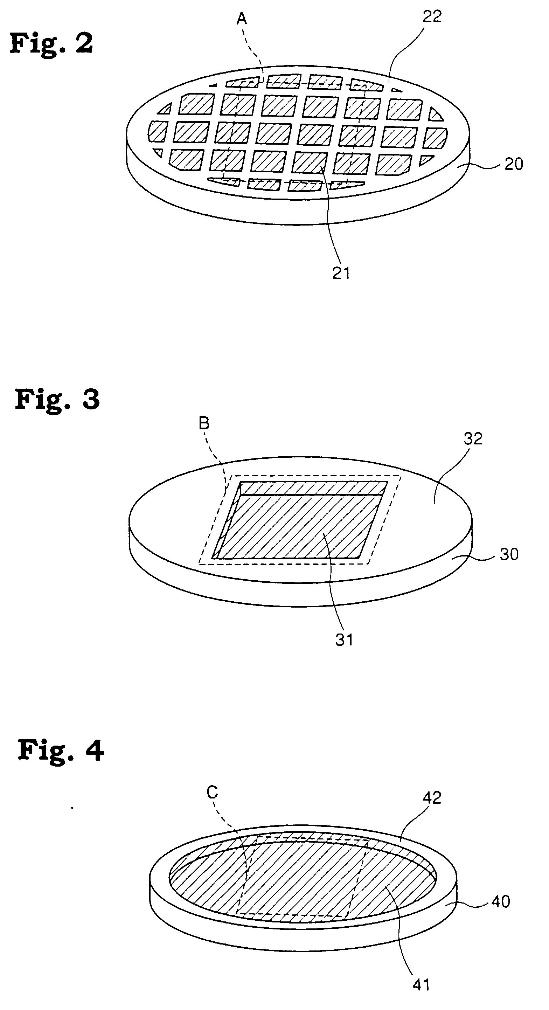

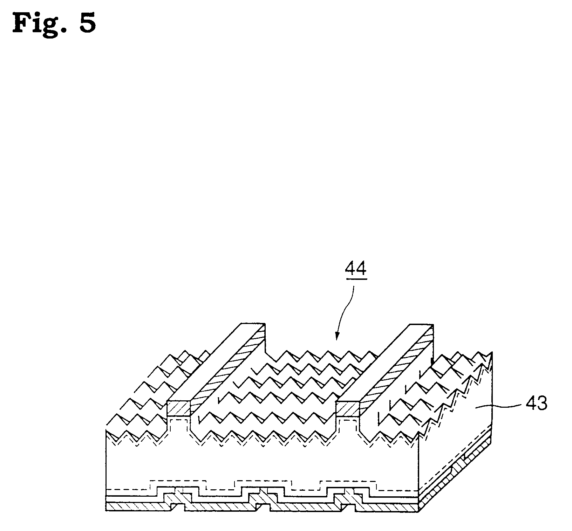

A two-dimentional shape of the thick portion and thin portion is not specifically limited. However, the two-dimentional shape is preferably disposed uniformly over the entire surface of the substrate. Especially, if the thick portion and thin portion are formed in both the front and rear surfaces of the substrate, a single pattern may be formed on both the front and rear surfaces of the substrate or, alternatively, different patterns may be formed on the front surface and on the rear surface as long as it has the above-mentioned substrate thickness or substrate strength. Here, it is preferable that the pattern is formed only on one surface of the substrate, more preferably on the front surface, in view of the substrate strength and the facility of treatment the substrate in the later steps. The specific shape of the thick portion and thin portion may be such that the thick portion and thin portion have a lattice shape (See Fig. 2); the thick portion and thin portion have alternate stripes along the vertical, horizontal and oblique directions; the thick portion and thin portion have a vortex shape; the thick portion or thin portion has an island shape; the thick portion is located only in a periphery of the element-forming substrate (See Fig. 4); the thick portion is located in an outer periphery in a shape that is finally cut out into the high-strength thin semiconductor element (See Fig. 3); or the thick portion is located only in a portion at which an electrode is to be formed in the high-strength thin semiconductor element finally completed (See Fig. 5). If the thick portion and thin portion are to be formed in a lattice shape, it is preferable that the size of the thin portion is smaller than the size of the substrate that is finally cut out into the high-strength thin semiconductor element, namely, it is preferable that both the thick portion and thin portion are disposed within the substrate of this size. The same would apply if the thick portion and thin portion are formed in a stripe shape, a vortex shape or an island shape. For example, the width or diameter of the thick portion in this case may be about 1 to about 20 mm. If the width or diameter is smaller than 1 mm, it is not possible to give a sufficient strength to the substrate. On the other hand, if the width or diameter is larger than 20 mm, it is not preferable in view of obtaining a high resistance to radioactive rays. Here, if the thick portion is to be formed only in the periphery of the substrate, the size of the thin portion may be larger the size of the substrate that is finally cut out into the high-strength thin semiconductor element, namely, the size of the thin portion may be such that the thick portion is not present in the substrate of this size.

The thin portion may have a thickness smaller than the thick portion and larger than or equal to about 20 µm, preferably within the range of about 20 to about 100 µm. If the thin portion has a thickness smaller than about 20 µm, it is not preferable because it is difficult to obtain a suitable substrate strength, causing obstacles in the later steps, and to absorb a sufficient amount of incident light, yielding an insufficient output. The thin portion may be formed by etching and removing a portion of the substrate as initially used to a depth of, for example, about 20 µm to about 380 µm, preferably about 20 µm to about 200 µm, although the depth to be etched may be suitably adjusted depending on the thickness of the substrate as initially used or the like. The thickness of the thick portion is not specifically limited as long as the substrate has a sufficient strength to withstand the treatments performed in the later steps for forming the element as mentioned above. The thickness of the thick portion may be, for example, about 40 µm to about 400 µm, preferably about 50 µm to about 200 µm.

The element-forming substrate of the present invention can be applied for forming any semiconductor element that must be thin and have a high strength. Examples of the semiconductor elements to which the element-forming substrate of the present invention can be applied include solar cells, among which a solar cell for the universe is preferable because a high resistance to radioactive rays can be obtained while maintaining a sufficient substrate strength.

The high-strength thin semiconductor element of the present invention is obtained by forming an active layer in the above-mentioned element-forming substrate itself and forming it into a substrate cut out in a shape that constitutes the final high-strength thin semiconductor element (hereafter simply referred to as a "substrate"). The substrate has a thickness, a shape and the like that are similar to those of the element-forming substrate, and the thick portion and thin portion are formed in the front surface, which acts as a light-receiving surface in the final high-strength thin semiconductor element, in the rear surface, or in both the front and rear surfaces of the substrate. Here, if the thick portion is formed in the front surface of this substrate, the thick portion preferably occupies 1 to 20% of the area of the front surface. Also, the front surface of this substrate may have a texture structure in the thin portion so as to increase the light-receiving area. In this case, the substrate thickness at a portion having the smallest thickness in the texture structure is preferably 20 µm or more, which is the thickness of the thin portion.

If the high-strength thin semiconductor element is particularly a solar cell or a solar cell for the universe, the high-strength thin semiconductor element includes an n-type diffusion layer formed in the front surface of the substrate, a light-receiving surface electrode formed on a partial region of the n-type diffusion layer, a reflection-preventive film formed over the entire front surface of the substrate, a p-type diffusion layer formed in the rear surface of the substrate, and the rear surface electrode formed on the p-type diffusion layer.

Preferably, the n-type diffusion layer and p-type diffusion layer are formed in the entire front surface and in the entire rear surface of the substrate respectively. The n-type diffusion layer and p-type diffusion layer can be formed at a dopant concentration that is used in a general solar cell. For example, the diffusion layers may be formed at a dopant concentration of about 1 x 10¹⁸ to 1 x 10²⁰ atoms/cm³ for the n-type diffusion layer and 1 x 10¹⁸ to 1 x 10²⁰ atoms/cm³ for the p-type diffusion layer. Here, between the n-type diffusion layer and p-type diffusion layer, an impurity is present at a low concentration (for example, a p-type dopant such as phosphorus or arsenic is present at a dopant concentration of about 1 x 10¹⁴ to 1 x 10¹⁶ atoms/cm³). The junction depths of these layers may be suitably adjusted depending on the size, the efficiency and the like of the solar cell. For example, the junction depths may be each about 0.09 µm to about 0.29 µm for the n-type diffusion layer and about 0.5 µm to about 0.7 µm for the p-type diffusion layer if the thick portion of the substrate has a thickness of about 100 µm and the thin portion of the substrate has a thickness of about 20 µm. Here, if the front surface has a texture structure in order to increase the light-receiving area in the front surface of the substrate, the n-type diffusion layer is preferably formed over the entire front surface having the texture structure. Further, a region of contact between the p-type diffusion layer and a later-mentioned rear surface electrode in the rear surface of the substrate preferably has a BSF (Back Surface Field) structure in which a p-type high-concentration dopant diffusion layer is formed. In the case of the BSF structure, carriers that are photo-generated near the rear surface of the substrate can be effectively collected by an electric field of the p-type high-concentration dopant diffusion layer to heighten the efficiency, so that the BSF structure is effective in improving the sensitivity of the solar cell mainly to a long-wavelength light.

The light-receiving surface electrode and rear surface electrode can be formed of an electrically conductive material that is generally used in constructing a semiconductor element, for example, a single-layer film of a metal such as aluminum, silver, copper, nickel, lead, titanium, tantalum, tungsten, cobalt, gold, or a laminated film of these metals, such as Ti/Pd/Ag, Al/Ti/Pd/Ag, Ti/Ag or Au/Zn/Ag. Among these, a metal film for rear surface electrode such as Al/Ti/Pd/Ag having a high reflectivity is preferable. The thickness of these electrodes is not specifically limited and may be, for example, about 1 µm to about 10 µm. Also, the light-receiving surface electrode can be formed in a comb shape or a lattice shape occupying about 1 to about 10 % of the area of the light-receiving surface so as to increase the amount of light incident into the solar cell. Here, the light-receiving surface electrode may be formed only on a part or all of the thick portion of the substrate, or may be formed on a part of the thick portion and thin portion, or may be formed only on a part of the thin portion. The rear surface electrode is preferably formed in the whole rear surface except for the outer periphery of the element occupying about 80% or more of the area of the rear surface of the substrate so that the light being incident into the light-receiving surface and reaching the rear surface without being absorbed by the substrate can be reflected by the rear surface to be absorbed within the substrate.

The reflection-preventive film is used to reduce the reflection of light radiated onto the light-receiving surface. The material of the reflection-preventive film is not specifically limited as long as it is a material that is generally used to prevent reflection of light. For example, the reflection-preventive film may be formed of a single-layer film such as TiO₂, Al₂O₃, SiO₂, Ta₂O₅ or Nb₂O₅, or a laminated film thereof such as TiO₂/Al₂O₃ or TiO₂/SiO₂. The thickness of the reflection-preventive film is not specifically limited and may be, for example, about 500 to about 2000 Å. The reflection-preventive film is preferably formed to occupy about 90 to about 100 % of the area of the light-receiving surface, more preferably over the entire surface of the light-receiving surface.

In the present invention, the thick portion and thin portion may be formed in the element-forming substrate by forming a mask on a region of the front surface, the rear surface, or both the front and rear surfaces of the substrate which region is to become the thick portion and selectively removing, by means of the mask, a region of the substrate which region is to become the thin portion. Specifically, an insulating film is first formed on both the front and rear surfaces of the element-forming substrate as initially used, and then etching and removing, by the photolithography and etching technique, the insulating film formed in a portion of the front surface and/or rear surface on which the thin portion is to be formed, and further etching the substrate by a chemical etching method using the insulating film formed in a desired pattern as a mask. Here, a material capable of acting as an etching mask, such as a tape resistant to chemical etching, may be used suitably or by patterning it beforehand in a desired shape, instead of using the insulating film.

Another method of forming the thick portion and thin portion in the substrate is to utilize one of the steps for forming the semiconductor element on the element-forming substrate, for example, one of the later-mentioned steps.

In the method for manufacturing the high-strength thin semiconductor element, a pn junction which functions as an active layer of the solar cell is formed in the front surface of the obtained substrate for forming the high-strength thin semiconductor element, namely, in the surface which is to become the light-receiving surface of the high-strength thin semiconductor element finally completed. The n-type diffusion layer for this step may be formed by a known method such as ion implantation or thermal diffusion. Here, before or after forming the pn junction, it is preferable to form a p-type diffusion layer in the rear surface of the obtained substrate for forming the high-strength thin semiconductor element, namely, in the surface which is to become the rear surface of the high-strength thin semiconductor element finally completed. The p-type diffusion layer may be formed by a known method such as ion implantation or thermal diffusion.

Then, a light-receiving surface electrode is formed on the front surface of the substrate and the rear surface electrode is formed on the rear surface of the substrate. These electrodes may be formed by a known method such as vacuum vapor deposition, BE vapor deposition, or sputtering. Here, either one of the light-receiving surface electrode and rear surface electrode may be formed prior to the other one. Also, the n-type diffusion layer may be formed first, then the light-receiving surface electrode may be formed, and further the p-type diffusion layer may be formed. Also, the p-type diffusion layer may be formed first, then the rear surface electrode may be formed, and further the n-type diffusion layer may be formed.

Subsequently, individual solar cell elements for the universe are cut out from the substrate for forming the high-strength thin semiconductor element on which substrate the diffusion layers, the electrodes and the like are formed. The elements may be cut out by a known dicing process. Preferably, the high-strength thin semiconductor elements are cut out so that the thick portion is present in a lattice shape, a stripe shape, an island shape, or the like in the substrate constituting the high-strength thin semiconductor element, or so that the thin portion is present inside the substrate and the thick portion is present in the outer periphery of the substrate. Alternatively, if the thick portion and thin portion are present in the light-receiving surface, the high-strength thin semiconductor elements may be cut out so that the high-strength thin semiconductor element is disposed only in the thin portion.

More specifically, the above-mentioned high-strength thin semiconductor element may be formed by carrying out a series of steps as shown below.
(1) A first oxidation step for forming an oxide film on both surfaces of an element-forming substrate.
(2) A step of opening a window through the oxide film for use as a mask in forming a reflection-free surface configuration on one surface of the element-forming substrate.
(3) A texture etching step for forming the reflection-free surface configuration.
(4) A second oxidation step for forming an oxide film again on both surfaces of the element-forming substrate.
(5) A step of removing the oxide film on the rear surface of the element-forming substrate to form a first conductivity type dopant diffusion layer.
(6) An oxidation step for forming an oxide film again on the rear surface of the element-forming substrate.
(7) A step of removing the oxide film on the front surface of the element-forming substrate to form a second conductivity type dopant diffusion layer.
(8) A step of forming a passivation film on the front surface of the element-forming substrate.
(9) A step of removing the oxide film and the passivation film on the front and rear surfaces of the element-forming substrate, respectively, in a desired shape to form electrodes on the front and rear surfaces of the element-forming substrate for connection with the dopant diffusion layers.
(10) A step of forming a reflection-preventive film on the front surface of the element-forming substrate.
(11) A step of cutting the element-forming substrate into a final size(into the substrate).

Here, the above-mentioned steps may be carried out in a suitable different order. Also, a thermal treatment may be carried out at an arbitrary stage of the above steps in order to promote diffusion of dopants and to improve contact with the electrodes. Also, at an arbitrary stage of the above step before cutting the element-forming substrate into a final size, the element-forming substrate may be cut into a suitable shape and a suitable size that facilitate treatment. Therefore, a portion of the oxide film, for example, may be etched and removed to leave a predetermined portion of the oxide film to be used as a mask in the texture etching step of (3) (for example, a portion where an electrode is to be formed at a later step, only an outer periphery of the substrate size which becomes the element at a later step, a combined portion thereof or the like) for thinning the element-forming substrate, and further the element-forming substrate may be etched and patterned into a reflection-free surface configuration by an ordinary step to reduce the thickness of the element-forming substrate entirely or partially.

Hereafter, with reference to the attached drawings, an explanation will be given on a substrate for forming a high-strength thin semiconductor element, a high-strength thin semiconductor element, and a method for manufacturing a high-strength thin semiconductor element according to the present invention.

### Example 1

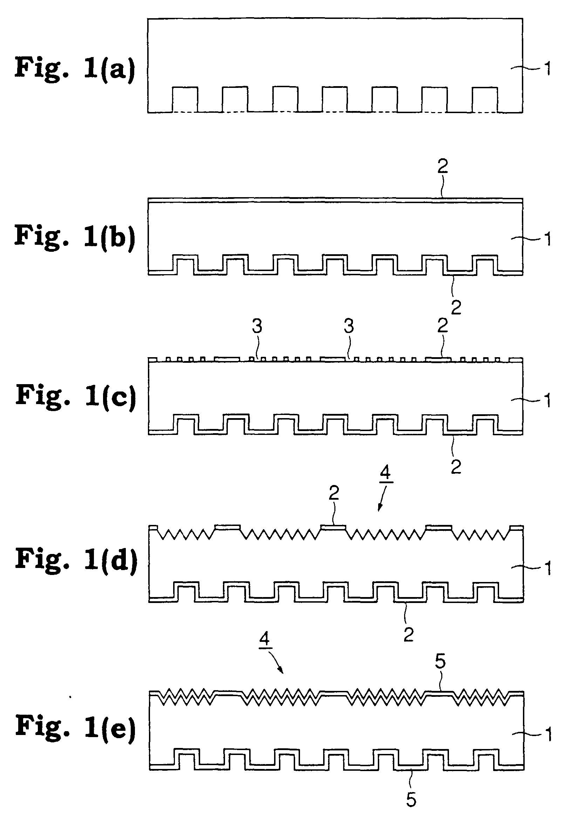

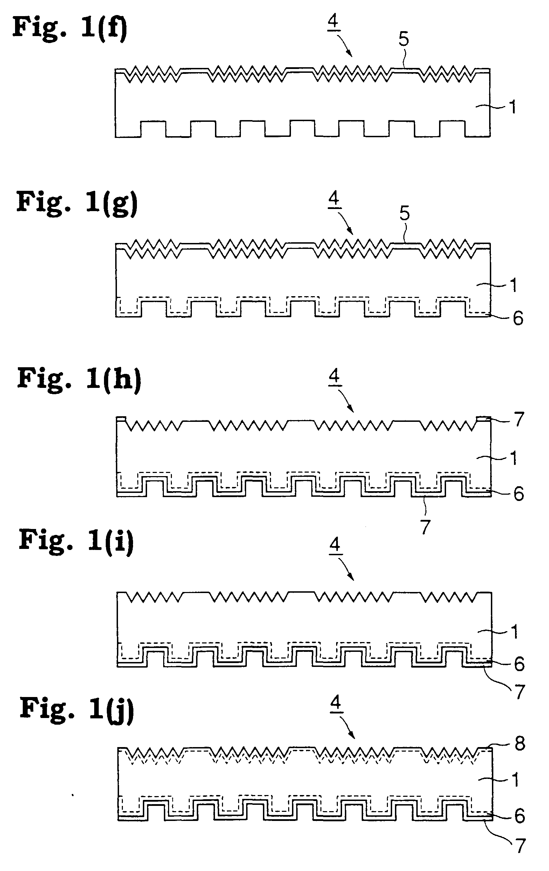

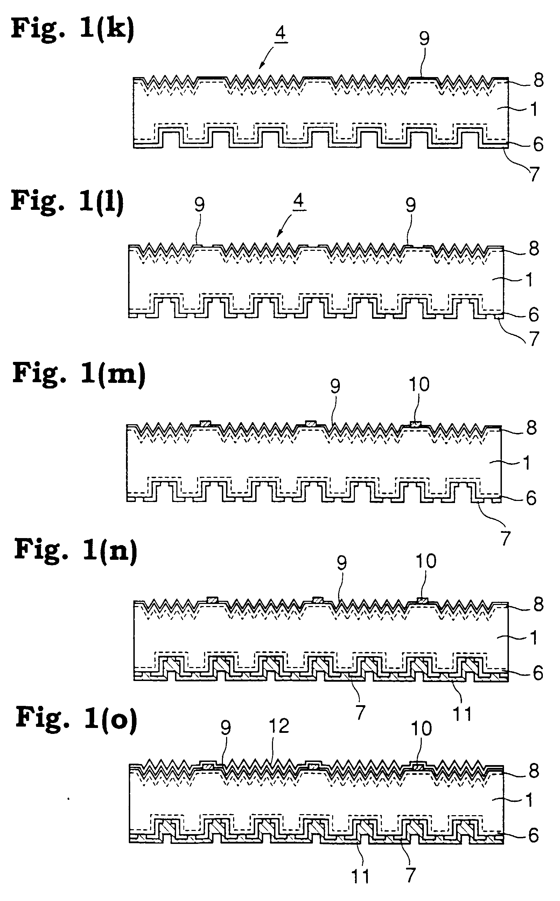

An oxide film (not shown) is formed on both surfaces of a silicon substrate 1 as initially used which is etched by a thinning etching step and having a thickness of about 100 µm. Then, a portion to be thinned in the oxide film on the rear surface of the silicon substrate 1 is selectively removed by a photolithography and etching technique. Thereafter, the rear surface of the substrate 1 is partially etched and removed by, for example, the RIE method using the oxide film as a mask to reduce the thickness of the substrate 1 (Fig. 1(a)). At this time, the etching depth is set to be about 50 µm and the thickness of the portion having the smallest thickness is set to be about 35 µm.

Subsequently, as a first oxidation step, an oxide film 2 is formed to a thickness of about 3000 Å on both surfaces of the silicon substrate 1 by thermal oxidation (Fig. 1(b)).

Next, windows 3 are opened through the oxide film 2 for a reflection-free surface configuration pattern by the photolithography and etching technique (oxide film window opening step: Fig. 1(c)).

A reflection-free surface configuration 4 for reducing reflection of light is formed on the front surface by etching only a portion where the oxide film 2 has been removed by the above oxide film window opening step (texture etching step : Fig. 1(d)). The texture etching step at this time is carried out on condition that the silicon substrate is provided before its initial introduction taking into account the direction along which the crystal is liable to be etched easily by utilizing the fact that a (111) crystal direction of a silicon single crystal is liable to be etched easily by an alkali solution (KOH, NaOH) as compared with the other (100), (010) and (001) crystal directions of the single crystal. When the silicon oxide film is patterned for masking in the texture etching step, the pattern is made into a lattice-like pattern with a predetermined spacing (opened window portion in the lattice: 20 µm x 20 µm, lattice portion : line width 2 µm). By this step, the lattice-like pattern is prepared in which squares of a predetermined size (20 µm x 20 µm) are arranged. By etching the patterned silicon substrate with an alkali, an inverse-pyramid structure is formed with a square portion (20 µm x 20 µm) being a bottom surface of a pyramid (quadrangular pyramid). Since the squares are arranged in order, the reflection-free surface configuration is formed with the inverse-pyramid structures being arranged in order. Here, by leaving the oxide film in a predetermined pattern in the previous step, the reflection-free surface configuration is made into the inverse-pyramid structure.

Next, as a second oxidation step, an oxide film 5 is formed again to a thickness of about 3000 Å on both surfaces of the substrate 1 by thermal oxidation (Fig. 1(e)).

In order to diffuse a p-type dopant into the rear surface of the substrate 1, the oxide film 5 formed on the rear surface is removed by dissolving SiO₂ by a chemical treatment, for example, using HF (Fig. 1(f)).

Subsequently, the substrate 1 is treated in a diffusion furnace (diffusion temperature : about 1000°C, carrier gas : BBr₃) to thermally diffuse boron ions, which exist in the diffusion atmosphere, into the rear surface of the substrate 1, so as to form a p-type diffusion layer 6 (Fig. 1(g)).

Thereafter, an oxide film 7 is formed to a thickness of about 4000 Å over the entire rear surface for protection of the rear surface by the CVD method (Fig. 1(h)).

The oxide film 7 formed by the CVD method and turning around onto the front surface (light-receiving surface) of the substrate 1 is removed by dissolving SiO₂ by a chemical treatment, for example, using HF (Fig. 1(i)).

Next, the substrate 1 is treated in a diffusion furnace (diffusion temperature : about 800°C, carrier gas: POCl₃) to diffuse phosphorus ions, which exist in the diffusion atmosphere, into the front surface of the substrate 1, so as to form an n-type diffusion layer 8 only on the light-receiving surface (Fig. 1(j)).

Subsequently, the substrate 1 is thermally oxidized to form a passivation film (oxide film) 9 having a thickness of about 200 Å on the n-type diffusion layer 8 in the front surface of the substrate 1 (Fig. 1(k)).

For connection of the diffusion layers 6, 8 with electrodes to be formed in later steps, electrode contact portions in the oxide film 7 on the rear surface of the substrate 1 and in the passivation film 9 on the front surface of the substrate 1 are respectively removed by the photolithography and etching technique (Fig. 1(l)).

A light-receiving surface electrode 10 of a predetermined shape is formed on the front surface of the substrate 1 for connection with the n-type diffusion layer 8 (N-electrode deposition step : Fig. 1(m)). Here, as a material for the electrode, a three-layer metal of Ti/Pd/Ag (having a thickness of 500 Å /400 Å / 6.5 µm) is used.

The substrate 1 is cut into a predetermined size in order to simplify the treatments to be performed in the later steps (dicing/breaking step I).

The rear surface electrode 11 of a predetermined shape is formed on the rear surface of the substrate 1 for connection with the p-type diffusion layer 6 (P-electrode deposition step : Fig. 1(n)). Here, as a material for the electrode, a four-layer metal of Al/Ti/Pd/Ag (having a thickness of 1500 Å /500 Å /400 Å /5.0 µm) is used.

A reflection-preventive film 12 is formed on the front surface of the substrate 1 by using a two-layer oxide of TiO₂/Al₂O₃ (having a thickness of 800 Å / 1100 Å) for reducing reflection of light (reflection-preventive film deposition step : Fig. 1(o)).

Subsequently, the substrate is thermally treated in an N₂ atmosphere at a temperature of 415°C for about 30 minutes so as to increase the degree of contact of the substrate 1 with the light-receiving surface electrode 10 and rear surface electrode 11 formed in the N/P-electrode deposition steps (sintering step).

The substrate 1 is cut into a final solar cell dimension (40 mm x 70 mm) (dicing breaking step II).

### Example 2

In Example 1, only the rear surface of the substrate is partially etched for reducing the thickness of the substrate. However, in this Example, a further reduction of the thickness of the substrate is carried out by uniformly etching a portion of the rear surface of the substrate or by uniformly etching the entire front surface of the substrate. The subsequent steps are all carried out in the same manner as in Example 1.

### Example 3

In Example 1, an oxide film is used as a protection film against chemical etching at the time of thinning the substrate. However, in this Example, a tape resistant to chemical etching and having a predetermined pattern formed therein is stuck onto a substrate as initially used, whereby the substrate is thinned by carrying out a conventional thinning chemical etching process and removing the tape resistant to chemical etching. The subsequent steps are all carried out in the same manner as in Example 1.

### Example 4

In this Example, a recess pattern 21 is formed in a lattice shape having a width of about 5 mm, as shown in Fig. 2, at the time of partially etching the rear surface of a substrate 20. The other steps are all carried out in the same manner as in Example 1. Here, since the final dimension of a solar cell obtained in this Example is a size of 40 mm x 70 mm (broken line A in Fig. 2), both the recess pattern 21 and a thick portion 22 remain in the final substrate of the obtained solar cell.

### Example 5

In this Example, a recess pattern 31 is formed in a lattice shape having a width of about 30 mm, as shown in Fig. 3, at the time of partially etching the rear surface of a substrate 30. The other steps are all carried out in the same manner as in Example 1. Here, since the final dimension of a solar cell obtained in this Example is a size of 40 mm x 70 mm (broken line B in Fig. 3), the final substrate of the obtained solar cell has a shape such that the recess pattern 31 is disposed inside the substrate 30 and a thick portion 32 is disposed in the outer periphery of the substrate 30.

### Example 6

In this Example, in partially etching only the rear surface of a substrate 40 as initially used, a recess pattern 41 is formed at a portion of the substrate 40 other than its outer periphery, as shown in Fig. 4, to leave a thick portion 42 only in the outer periphery of the substrate 40.

By using the substrate 40, the steps up to the formation of an N-electrode are carried out in the same manner as in Example 1. During these steps, the strength of the substrate 40 is maintained at a high level with the help of the thick portion in the outer periphery of the substrate 40, so that generation of defective products due to cracks in the substrate can be prevented.

Then, after the formation of the N-electrode, in cutting out the substrate at the dicing breaking step I, the outer periphery of the substrate 40 is cut off to leave a substrate having a size of about 80 mm x about 80 mm (broken line C in Fig. 4). This makes it possible to carry out most of the steps for manufacturing a thin solar cell element in a state of a high-strength substrate, thereby increasing the yield in manufacturing the solar cell elements.

### Example 7

In this Example, the steps up to the first oxidation step are carried out in the same manner as in Example 1. Thereafter, at the step of opening a window through an oxide film, the oxide film is removed except for the portion at which an N-electrode is to be formed.

Subsequently, the substrate is etched for reduction of its thickness except for the portion at which the N-electrode is to be formed, thereby to leave the N-electrode formation portion as a thick film.

Thereafter, the substrate is subjected to a texture etching step in the same manner as in Example 1 to form a reflection-free surface configuration. At this time, since the entire oxide film has been removed by the previous oxide film window opening step except for the portion at which the N-electrode is to be formed, the reflection-free surface configuration (texture configuration) takes a random texture configuration as shown in Fig. 5 instead of the repetition of a fixed pattern (inverse-pyramid shape) as shown in Fig. 11.

The texture etching step at this time is different from the one mentioned above. When a surface of silicon is etched with an alkali without using a fixed masking pattern, the etching proceeds beginning from numerous active portions on the silicon surface. In other words, since these etching-starting portions (active portions) are present in a random manner on the silicon substrate, the surface of the substrate obtained by the etching process takes a random texture configuration instead of a repetition of a fixed inverse pyramid. The subsequent steps are carried out in the same manner as in Example 1.

In this Example, there is no need to perform the steps of forming an oxide film on a silicon substrate as initially used, selectively removing the oxide film, and then carrying out a chemical etching process to reduce the thickness of the substrate as shown in Example 1. Therefore, it is possible to prevent complication of the steps, whereby an element with increased strength and reduced thickness can be realized extremely easily.

### Example 8

By a thinning etching process, a silicon substrate having a thickness of about 100 µm as initially used is chemically etched at a portion to be thinned, i.e. except for a thick portion that acts to maintain a substrate strength.

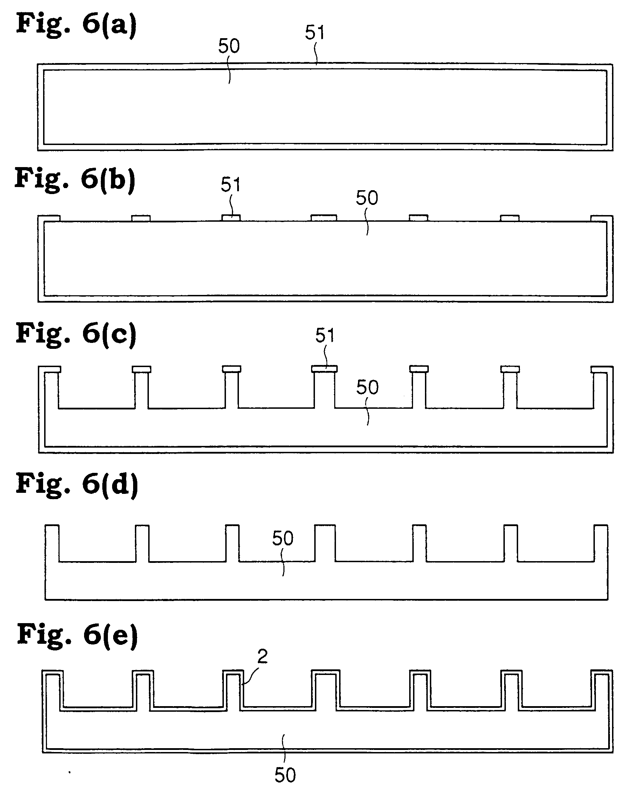

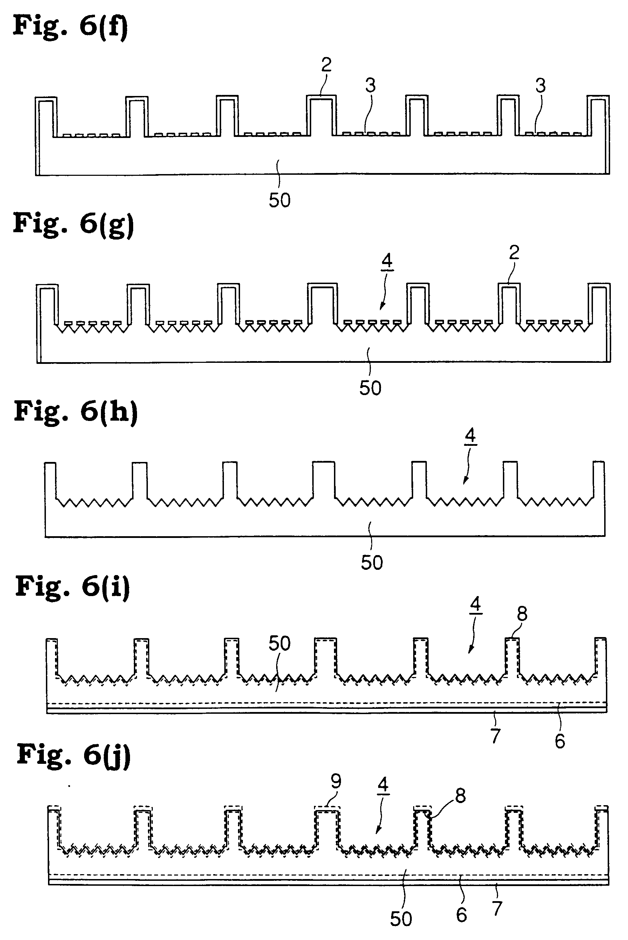

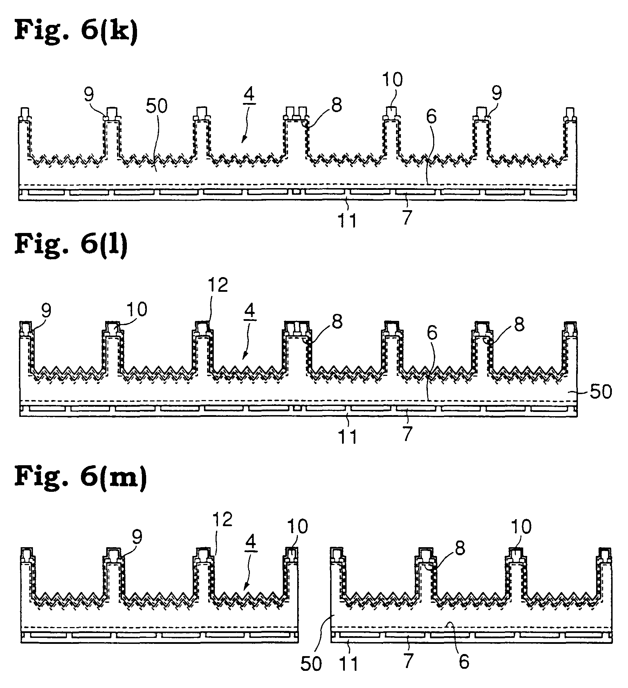

Namely, an oxide film 51 is formed on both surfaces of a silicon substrate 50 (Fig. 6(a)). Then, by a photolithography and etching technique, the oxide film 51 is selectively removed at a portion to be thinned on the front surface of the silicon substrate 50 which surface is to become a light-receiving surface in a completed solar cell (Fig. 6(b)).

Thereafter, the front surface of the silicon substrate 50 is partially etched and removed by, for example, the RIE method using the oxide film 51 as a mask, so as to reduce the thickness of the substrate (Fig. 6(c)). An etching depth at this time is about 50 µm and the thickness of the portion having the smallest thickness is about 35 µm. An increased strength is obtained if the etching is carried out for a depth of 20 µm or more to allow the thick portion to have a thickness larger than the thin portion by 20 µm m or more. If the thin portion has a thickness of less than 20 µm, it is not possible to obtain a sufficient substrate strength, causing obstacles in the later treatments, such as generation of cracks, and the incident light is not sufficiently absorbed within the substrate, thereby decreasing the output of the solar cell element. On the other hand, if the thin portion has a thickness of more than 100 µm, it is not possible to obtain a sufficient resistance to radioactive rays. Also, it is effective if the thick portion occupies 1 to 20% of the total front surface area of the solar cell element. If the area of the thick portion is less than 1%, it is not possible to obtain sufficient substrate strength. On the other hand, if the area of the thick portion is more than 20%, it is not possible to obtain a sufficient resistance to radioactive rays.

Subsequently, the oxide film 51 used as a mask is removed (Fig. 6(d)).

Thereafter, as a first oxidation step, an oxide film 2 is formed to a thickness of about 3000 Å on both surfaces of the silicon substrate 50 by thermal oxidation (Fig. 6(e)).

Then, a window 3 for a reflection-free surface configuration pattern is opened through the oxide film 2 by the photolithography and etching technique (oxide film window opening step: Fig. 6(f)).

A reflection-free surface configuration 4 for reducing reflection of light is formed on the front surface by etching only a portion where the oxide film 2 has been removed by the above oxide film window opening step (texture etching step : Fig. 6(g)). The etching process at this time can be carried out in the same manner as in Example 1. Here, since the thickness of the substrate is partially further reduced by further performing the texture etching process on the thin portion at this step, the portion having the smallest thickness in the thin portion is allowed to have a thickness of 20 µm or more.

Then, the oxide film 2 used as a mask is removed (Fig. 6(h)).

Subsequently, as a second oxidation step, an oxide film (not shown) is formed to a thickness of about 3000 Å again on both surfaces of the silicon substrate 50 by thermal oxidation.

In order to diffuse a p-type dopant into the rear surface of the silicon substrate 50, the oxide film formed on the rear surface is removed by using HF.

Next, a p-type diffusion layer 6 is formed to construct a BSF structure by treating the silicon substrate 50 in a diffusion furnace to thermally diffuse boron ions, which exist in a diffusion atmosphere, into the rear surface of the silicon substrate 50. If the thin portion has a small thickness, a BSF effect is great because the carriers which are present around the rear surface in a small amount can be effectively utilized. Especially, if the thin portion has a thickness of 100 µm or less, the BSF structure is effective. Thereafter, an oxide film 7 is formed to a thickness of about 4000 Å over the entire rear surface for protection of the rear surface by the CVD method. Then, the oxide film 7 formed by the CVD method and turning around onto the front surface (light-receiving surface) of the substrate 50 is removed by using HF. Next, the silicon substrate 50 is treated in a diffusion furnace to diffuse phosphorus ions, which exist in a diffusion atmosphere, into the front surface of the silicon substrate 50, so as to form an n-type diffusion layer 8 only on the light-receiving surface (Fig. 6(i)).

Subsequently, the silicon substrate 50 is thermally oxidized to form a passivation film 9 having a thickness of about 200 Å on the n-type diffusion layer 8 in the front surface of the silicon substrate 50 (Fig. 6(j)).

For connection of the diffusion layers 6, 8 with electrodes to be formed in later steps, electrode contact portions in the oxide film 7 on the rear surface of the silicon substrate 50 and in the passivation film 9 on the front surface of the silicon substrate 50 are respectively removed by the photolithography and etching technique. Then, an electrode 10 of a predetermined shape is formed on the front surface of the silicon substrate 50 for connection with the n-type diffusion layer 8. Here, as a material for the electrode, a three-layer metal of Ti/Pd/Ag is used. Also, an electrode 61 of a predetermined shape is formed on the rear surface of the silicon substrate 50 for connection with the p-type diffusion layer 6. Here, as a material for the electrode, a four-layer metal of Al/Ti/Pd/Ag is used (Fig. 6(k)).

If a high-reflectivity metal such as aluminum is used as the rear surface electrode, it produces an effect that the incident light reaching the rear surface without being absorbed by the substrate is reflected by the rear surface into the substrate, thereby heightening the absorptivity and increasing the output power of the solar cell element. This effect is great if the thin portion has a small thickness, because the ratio of the incident light reaching the rear surface without being absorbed by the substrate is large. Especially, if the thin portion has a thickness of 100 µm or less, the high-reflectivity metal is effective. Also, it is effective if the rear surface electrode occupies 80% or more of the area of the rear surface of the solar cell element.

Subsequently, a reflection-preventive film 12 is formed on the front surface of the silicon substrate 50 by using a two-layer oxide of TiO₂/Al₂O₃ for reducing reflection of light (Fig. 6(l)).

The substrate is then thermally treated in an N₂ atmosphere so as to increase the degree of contact of the silicon substrate 50 with the electrodes formed in the N/P-electrode deposition steps.

The silicon substrate 50 is diced into a final solar cell dimension (Fig. 6(m)). Since the thick portion is present in the cut-out solar cell element, the element can be maintained to have a high strength, thereby facilitating the handling of the element and improving the workability.

In this Example, only the portion where the light-receiving surface electrode 10 is to be formed is made into the thick portion, and the portion where the light-receiving surface electrode 10 is not to be formed is selectively etched and removed to reduce the thickness of the silicon substrate 50. This provides an effect that the silicon substrate 50 is not easily cracked even if a force is applied to the silicon substrate 50 by pressing or the like in connecting an interconnector to the light-receiving surface electrode 10 of the solar cell element.

### Example 9

In Example 8, only the front surface side of the silicon substrate, which is to become the light-receiving surface of the completed solar cell, is partially etched to reduce the thickness of the silicon substrate. In this Example, a further reduction of the thickness of the silicon substrate is carried out by uniformly etching a portion of the front surface of the silicon substrate or by uniformly etching the entire rear surface of the silicon substrate. The subsequent steps are all carried out in the same manner as in Example 8.

### Example 10

In Example 8, an oxide film is used as a protection film against chemical etching at the time of thinning the silicon substrate. However, in this Example, a tape resistant to chemical etching and having a predetermined pattern formed therein is stuck onto a silicon substrate as initially used, whereby the silicon substrate is thinned by carrying out a conventional thinning chemical etching process and removing the tape resistant to chemical etching. The subsequent steps are all carried out in the same manner as in Example 8.

### Example 11

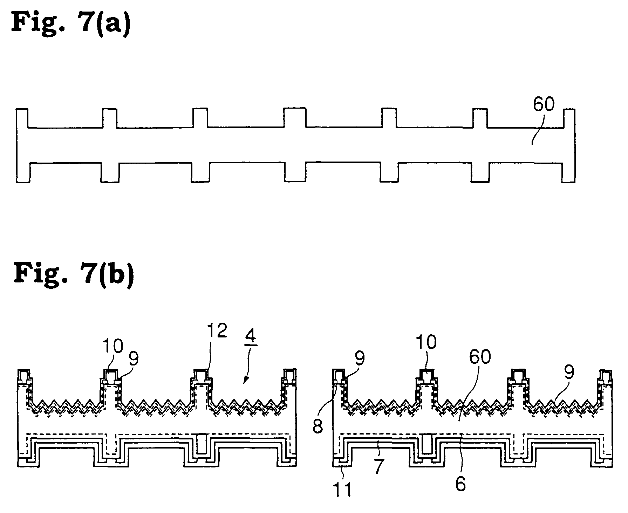

In Example 8, only the front surface side of the silicon substrate, which is to become the light-receiving surface electrode of the completed solar cell, is partially etched. In this Example, the thick portion is left on both the front and rear surfaces of the silicon substrate 60, and the other portion of the silicon substrate is selectively etched, as shown in Fig. 7(a). The subsequent steps are all carried out in the same manner as in Example 8, and the silicon substrate is diced into a final solar cell dimension, as shown in Fig. 7(b).

This makes it possible to carry out most of the steps for manufacturing the solar cell element by using a substrate having a thick portion on both the front and rear surfaces of the silicon substrate, thereby increasing the yield in manufacturing the solar cell elements. Also, since the front surface and rear surface are simultaneously etched, the treatment time is half of the total time required in separately etching the front surface and rear surface to the same depth when only one surface is etched at a time. Also, the silicon substrate can withstand the impacts from both the front surface and rear surface as compared with the case where the thick portion is present on only one surface of the silicon substrate. Also, since the thick portion is present within the final solar cell element, the strength of the element can be ensured even after the completion of the element, thereby facilitating the handling of the element and improving the workability.

Also, since the pattern of the thick portion is formed symmetrically on the front and rear surfaces of the silicon substrate, the thin portion of the silicon substrate is not brought into contact with a pressure applied onto both the front and rear surfaces of the silicon substrate, and the strength of the silicon substrate can be maintained because the thick portion acts as a pillar. Therefore the yield can be improved in the steo of mounting a substrate on a stage and pressing a tape from thereabove by a roller, such as in the step of sticking a tape for dicing.

### Example 12

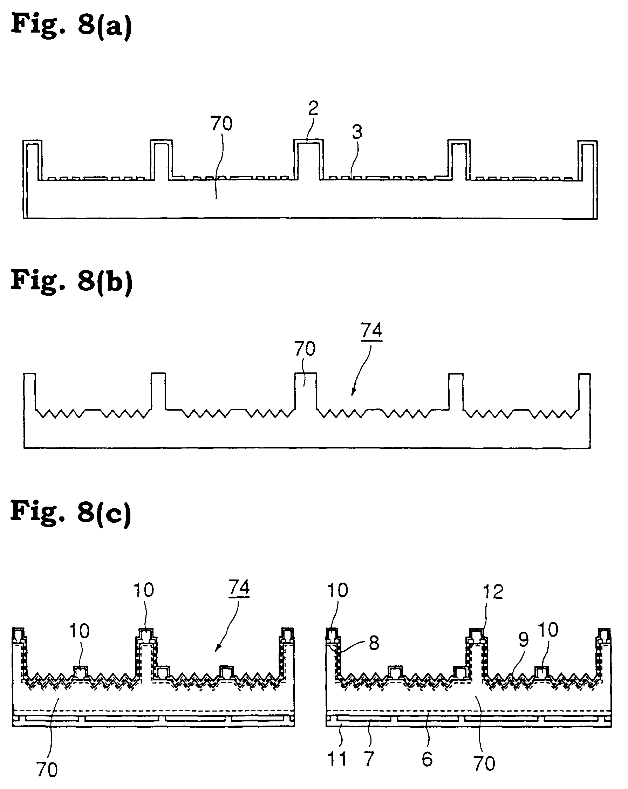

In Example 8, the reflection-free surface configuration is formed in a uniform pattern on the silicon substrate. In this Example, a thick portion and a thin portion are formed on the front surface of a silicon substrate 70, and then an oxide film 3 is patterned so that light-receiving surface electrodes 10 can be formed also on the thin portion, as shown in Fig. 8(a).

Then, the front surface of the thin portion of the silicon substrate 70 is etched by using this oxide film 3 as a mask to form a reflection-free surface configuration 74, as shown in Fig. 8(b).

The subsequent steps are all carried out in the same manner as in Example 8 except that the light-receiving surface electrodes 10 are formed on the thin portion as well as on the thick portion.

This completes a solar cell element in which the light-receiving surface electrodes 10 are formed on the thick portion and on the thin portion, as shown in Fig. 8(c).

### Example 13

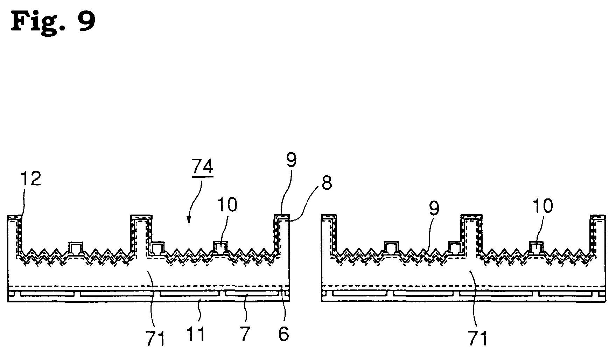

In Example 8, the light-receiving surface electrode 10 is formed only on the thick portion of the silicon substrate. In this Example, a reflection-free surface configuration 74 having a flat portion is formed on the front surface of a thin portion of a silicon substrate 71, and a light-receiving surface electrode 10 is formed only on the thin portion, as shown in Fig. 9. The subsequent steps are all carried out in the same manner as in Example 8.

In the case where the light-receiving surface electrode 10 is formed only on the thin portion, there is provided an effect that, if an interconnector is connected to the light-receiving surface electrode 10 of the solar cell element, the interconnector does not protrude out of the front surface of the solar cell element, thereby facilitating the later step of sticking a cover glass onto the silicon substrate 71 and the like treatment.

### Example 14

In this Example, a recess pattern 21 is formed in a lattice shape, as shown in Fig. 2, at the time of partially etching the front surface of a substrate 20. The other steps are all carried out in the same manner as in Example 8. Here, since the final dimension of a solar cell obtained in this Example is a size of 40 mm x 70 mm (broken line A in Fig. 2), both the recess pattern 21 and a thick portion 22 remain in the final substrate of the obtained solar cell.

### Example 15

In this Example, a recess pattern 31 is formed in a lattice shape having a width of about 30 mm, as shown in Fig. 3, at the time of partially etching the front surface of a substrate 30. The other steps are all carried out in the same manner as in Example 8. Here, since the final dimension of a solar cell obtained in this Example is a size of 40 mm x 70 mm (broken line B in Fig. 3), the final substrate of the obtained solar cell has a shape such that the recess pattern 31 is disposed inside the substrate 30 and a thick portion 32 is disposed in the outer periphery of the substrate 30.

This provides an effect that the defects, such as chipping (breaking) of a marginal portion of the solar cell element, can be reduced.

### Example 16

In this Example, in partially etching only the front surface of a substrate 40 as initially used, a recess pattern 41 is formed at a portion of the substrate 40 other than its outer periphery, as shown in Fig. 4, to leave a thick portion 42 only in the outer periphery of the substrate 40. At this time, the thick portion 42 in the outer periphery of the substrate 40 preferably has a width of about 1 mm to about 20 mm. If the width of the thick portion is smaller than 1 mm, it is not possible to obtain a sufficient strength. On the other hand, if the width of the thick portion is larger than 20 mm, a lot of portions must be discarded, so that it is not practical.

By using this substrate, the steps up to the formation of an N-electrode are carried out in the same manner as in Example 8. During these steps, the strength of the substrate is maintained at a high level with the help of the thick portion in the outer periphery of the substrate, so that generation of defective products due to cracks in the substrate can be prevented.

Then, after the formation of the N-electrode, in cutting out the substrate at the dicing/breaking step I, the outer periphery of the substrate is cut off to leave a substrate having a size of about 80 mm x about 80 mm (broken line C in Fig. 4).

This makes it possible to carry out most of the steps for manufacturing a thin solar cell element in a state of a high-strength substrate, thereby increasing the yield in manufacturing the solar cell elements.

Also, although not shown, if a plurality of solar cell elements are to be formed on a single substrate, the thick portion may exist only between these elements.

### Example 17

In this Example, a recess pattern 21 is formed in a lattice shape, as shown in Fig. 2, at the time of partially etching both front and rear surfaces of a substrate 20. The other steps are all carried out in the same manner as in Example 8 and in Example 11.

### Example 18

In this Example, a recess pattern 31 is formed in a lattice shape having a width of about 30 mm, as shown in Fig. 3, at the time of partially etching both front and rear surfaces of a substrate 30. The other steps are all carried out in the same manner as in Example 8 and in Example 11. Here, since the final dimension of a solar cell obtained in this Example is a size of 40 mm x 70 mm (broken line B in Fig. 3), the final substrate of the obtained solar cell has a shape such that, on each of the front and rear surfaces of the substrate, the recess pattern 31 is disposed inside the substrate and a thick portion 32 is disposed in the outer periphery of the substrate.

### Example 19

In this Example, in partially etching both front and rear surfaces of a substrate 40 as initially used, a recess pattern 41 is formed at a portion of the substrate 40 other than its outer periphery, as shown in Fig. 6, to leave a thick portion 42 only in the outer periphery of the substrate 40. The other steps are all carried out in the same manner as in Example 8 and in Example 11.

According to the substrate for forming a high-strength thin semiconductor element of the present invention, it is possible to prevent decrease in the strength of the substrate itself which decrease is brought about in accordance with the reduction of the substrate. This provides an effect that the handling of the substrate is facilitated, the generation of defective products due to cracking or chipping of the substrate can be prevented, and the reduction of substrate transportation capability required in the apparatus to be used in the later steps can be realized.

Also, if a semiconductor element is fabricated by forming an active layer in a substrate itself for forming a high-strength thin semiconductor element according to the present invention, a further reduction in weight and thickness of the semiconductor element can be realized. Therefore, the substrate can be applied to various purposes, for example, fabrication of solar cell elements, especially solar cell elements for the universe that require thickness reduction, whereby high-strength thin semiconductor elements being highly efficient and highly reliable and having improved resistance to radioactive rays can be obtained.

In addition, by forming a thick portion and a thin portion to have a particular shape on a substrate for forming a high-strength thin semiconductor element according to the present invention, the substrate strength can be uniformly heightened in the surface, so that the substrate can be treated in the same manner as a conventional substrate. Especially, the handling of the completed element is facilitated if the thick portion and thin portion are formed in a shape that increases the strength of marginal portions of the completed substrate which portions are liable to generate cracking or chipping.

Also, in the case where the thick portion and thin portion are formed only on the front surface of the substrate, the floating and the like of the rear surface in the dicing step can be avoided to improve the yield, and air bubbles can be prevented from being generated in an adhesive in sticking the high-strength thin semiconductor element onto another substrate with the adhesive, so that the substrate can enjoy a wider range of application, making it possible to obtain a highly reliable high-strength thin semiconductor element.

Further, in the case where the thick portion and thin portion are formed on both the front and rear surfaces of the substrate, especially if the pattern of the thick portion is disposed symmetrically on the front surface and on the rear surface, the thin portion is not brought into contact with a pressure applied onto both the front and rear surfaces of the substrate, and the strength of the substrate can be maintained because the thick portion acts as a pillar. Therefore, cracking of the substrate can be reduced and contamination due to direct contact of the apparatus or the like with the thin portion can be prevented in a process such as dicing, thereby making it possible to obtain a highly reliable high-strength thin semiconductor element.

Also, according to the method for manufacturing a high-strength thin semiconductor element of the present invention, the yield and the ratio of good products can be increased in manufacturing high-strength thin semiconductor elements, because the high-strength thin semiconductor elements can be manufactured by using a substrate having a high substrate strength as shown above.

Although the present invention has fully been described by way of example with reference to the accompanying drawings, it is to be understood that various changes and modifications will be apparent to those skilled in the art. Therefore, unless otherwise such changes and modifications depart from the scope of the invention, they should be construed as being included therein.

## Claims

1. A substrate for forming a high-strength thin semiconductor element, comprising a thick portion and a thin portion in the front surface or in both front and rear surfaces of the substrate,
the thick portion maintaining a thickness of the substrate as initially used or having a thickness that gives a sufficient strength to the substrate,
the thin portion being formed by selectively removing a portion of the substrate other than the thick portion and having a thickness smaller than the thick portion and larger than or equal to 20 µm.

2. A substrate for forming a high-strength thin semiconductor element according to claim 1, wherein the thick portion has a line-like shape of being present in a periphery of the substrate, a lattice shape, a stripe shape or an island shape.

3. A substrate for forming a high-strength thin semiconductor element, comprising a thick portion and a thin portion in the rear surface of the substrate,
the thick portion maintaining a thickness of the substrate as initially used,
the thin portion being formed by selectively removing a portion of the substrate other than the thick portion and having a thickness smaller than the thick portion and larger than or equal to 20 µm.

4. A substrate for forming a high-strength thin semiconductor element according to claim 3, wherein the thick portion has a lattice shape, a stripe shape or an island shape.

5. A high-strength thin semiconductor element comprising;
an active layer formed in the substrate itself of claim 1,
a light-receiving surface electrode disposed on the front surface of the substrate, and
the rear surface electrode disposed on the rear surface of the substrate.

6. An element according to claim 5, wherein the thick portion has a line-like shape of being present in a periphery of the substrate, a lattice shape, a stripe shape or an island shape disposed in the front surface or in both the front and rear surfaces of the substrate.

7. An element according to claim 5 or 6, wherein the thick portion in the front surface of the substrate is formed to have a thickness larger than the thickness of the thin portion by 20 µm or more.

8. An element according to claims 5 or 6, wherein the thick portion in the front surface of the substrate occupies 1 to 20% of the area of the front surface.

9. An element according to claim 5 including;
an n-type diffusion layer formed in the front surface of the substrate, the light-receiving surface electrode being formed on a partial region of the n-type diffusion layer,
a reflection-preventive film formed over the entire front surface of the substrate, and
a p-type diffusion layer formed in the rear surface of the substrate,
the rear surface electrode being formed on the p-type diffusion layer,
wherein the thin portion has a thickness of 20 to 100 µm,
the front surface has a texture structure,
the rear surface electrode is formed to occupy 80% or more of the area of the rear surface of the substrate, and
a region of contact between the p-type diffusion layer and rear surface electrode has a BSF structure.

10. An element according to claim 9, wherein the light-receiving surface electrode is formed only on the thick portion or only on the thin portion of the front surface of the substrate.

11. A high-strength thin semiconductor element comprising;
an active layer formed in the substrate itself of claim 3,
a light-receiving surface electrode disposed on the front surface of the substrate, and
the rear surface electrode disposed on the rear surface of the substrate.

12. An element according to claim 11, wherein the thick portion has a lattice shape, a stripe shape or an island shape disposed in the rear surface of the substrate.

13. An element according to claim 11 or 12, wherein the thick portion in the rear surface of the substrate is formed to have a thickness larger than the thickness of the thin portion by 20 µm or more.

14. An element according to claim 11 including;
an n-type diffusion layer formed in the front surface of the substrate,
the light-receiving surface electrode being formed on a partial region of the n-type diffusion layer,
a reflection-preventive film formed over the entire front surface of the substrate, and
a p-type diffusion layer formed in the rear surface of the substrate,
the rear surface electrode being formed on the p-type diffusion layer,
wherein the thin portion has a thickness of 20 to 100 µm,
the front surface has a texture structure,
the rear surface electrode is formed to occupy 80% or more of the area of the rear surface of the substrate, and
a region of contact between the p-type diffusion layer and rear surface electrode has a BSF structure.

15. An element according to claims 9 or 14, wherein the high-strength thin semiconductor element is a solar cell or a solar cell for the universe.

16. A method of manufacturing a high-strength thin semiconductor element comprising the step of selectively removing a portion of both front and rear surfaces of a substrate by using a mask so as to leave a thick portion maintaining a thickness of the substrate as initially used or having a thickness that gives a sufficient strength to the substrate as well as to form a thin portion having a thickness smaller than the thick portion and larger than or equal to 20 µm.

17. A method of manufacturing a high-strength thin semiconductor element comprising the step of selectively removing a portion of the front surface of a substrate by using a mask so as to leave a thick portion maintaining a thickness of the substrate as initially used or having a thickness that gives a sufficient strength to the substrate as well as to form a thin portion having a thickness smaller than the thick portion and larger than or equal to 20 µm.

18. A method of manufacturing a high-strength thin semiconductor element comprising the step of selectively removing a portion of the rear surface of a substrate by using a mask so as to leave a thick portion maintaining a thickness of the substrate as initially used as well as to form a thin portion having a thickness smaller than the thick portion and larger than or equal to 20 µm.

19. A method of manufacturing a high-strength thin semiconductor element according to claim 16 or 17, further comprising the steps of;
forming a pn junction in the front surface of the substrate,
forming a light-receiving surface electrode on the front surface of the substrate acting as a light-receiving surface of the high-strength thin semiconductor element,
forming the rear surface electrode on the rear surface of the substrate, and
cutting out a solar cell element for the universe from the substrate.

20. A method of manufacturing a high-strength thin semiconductor element according to claim 18, further comprising the steps of;
forming a pn junction in the front surface of the substrate,
forming a light-receiving surface electrode on the front surface of the substrate acting as a light-receiving surface of the high-strength thin semiconductor element,
forming the rear surface electrode on the rear surface of the substrate, and
cutting out a solar cell element for the universe from the substrate.

21. A method of manufacturing a high-strength thin semiconductor element according to claim 19 or 20, wherein the high-strength thin semiconductor element is cut out so that the thick portion is present in a lattice shape, a stripe shape or an island shape in the substrate constituting the high-strength thin semiconductor element, or so that the thin portion is present inside the substrate and the thick portion is present in an outer periphery of the substrate.

22. A method of manufacturing a high-strength thin semiconductor element according to claim 19, wherein the high-strength thin semiconductor element is cut out so that the substrate constituting the high-strength thin semiconductor element is present only in the thin portion.

23. A semiconductor solar cell comprising a substrate and electrodes provided on the front and rear surfaces of said substrate, wherein at least one of said substrate surfaces has recesses formed by selective removal of the semiconductor material of the substrate so as to form relatively thin substrate portions, and projecting portions which remain between said recesses to form relatively thick, substrate-strengthening substrate portions.

24. A substrate for a semiconductor device, such as a solar cell in which portions of one or both surfaces are selectively removed to form thin substrate portions suited for optimum opto-electric performance and intermediate thick substrate portions for providing required substrate strength.
